(19) Europäisches Patentamt
European Patent Office
Office européen des brevets

(11) EP 2 766 990 B1

(12) FASCICULE DE BREVET EUROPEEN

(45) Date de publication et mention
de la délivrance du brevet:
**22.07.2015 Bulletin 2015/30**

(21) Numéro de dépôt: **12767000.8**

(22) Date de dépôt: **04.10.2012**

(51) Int Cl.:
*H03F 3/00* *(2006.01)*     *G01T 1/24* *(2006.01)*
*H03K 5/06* *(2006.01)*     *G01T 1/15* *(2006.01)*
*H03H 11/26* *(2006.01)*     *H03K 5/13* *(2014.01)*
*G01T 1/17* *(2006.01)*     *G01V 5/00* *(2006.01)*
*H02M 11/00* *(2006.01)*     *H03H 19/00* *(2006.01)*

(86) Numéro de dépôt international:
**PCT/EP2012/069585**

(87) Numéro de publication internationale:
**WO 2013/034779 (14.03.2013 Gazette 2013/11)**

(54) **DISPOSITIF DE CONVERSION D'IMPULSIONS DE COURANT EN IMPULSIONS DE TENSION**

VORRICHTUNG ZUR UMWANDLUNG VON STROMIMPULSEN IN SPANNUNGSIMPULSE

DEVICE FOR CONVERTING CURRENT PULSES INTO VOLTAGE PULSES

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **10.10.2011 FR 1159122**

(43) Date de publication de la demande:
**20.08.2014 Bulletin 2014/34**

(73) Titulaire: **Commissariat à l'Énergie Atomique
et aux Énergies Alternatives
75015 Paris (FR)**

(72) Inventeurs:
• **ROSTAING, Jean-Pierre
F-38260 La Côte Saint-Andre (FR)**
• **OUVRIER-BUFFET, Patrice
F-74410 Saint-Jorioz (FR)**

(74) Mandataire: **Ahner, Philippe et al
BREVALEX
95, rue d'Amsterdam
75378 Paris Cedex 8 (FR)**

(56) Documents cités:
**US-A- 5 453 710     US-A1- 2011 098 980**

## Description

## DOMAINE TECHNIQUE

L'invention concerne un dispositif de conversion d'impulsions de courant en impulsions de tension, utilisable notamment dans un système de détection de rayonnements électromagnétiques ionisants.

## ÉTAT DE LA TECHNIQUE ANTÉRIEURE

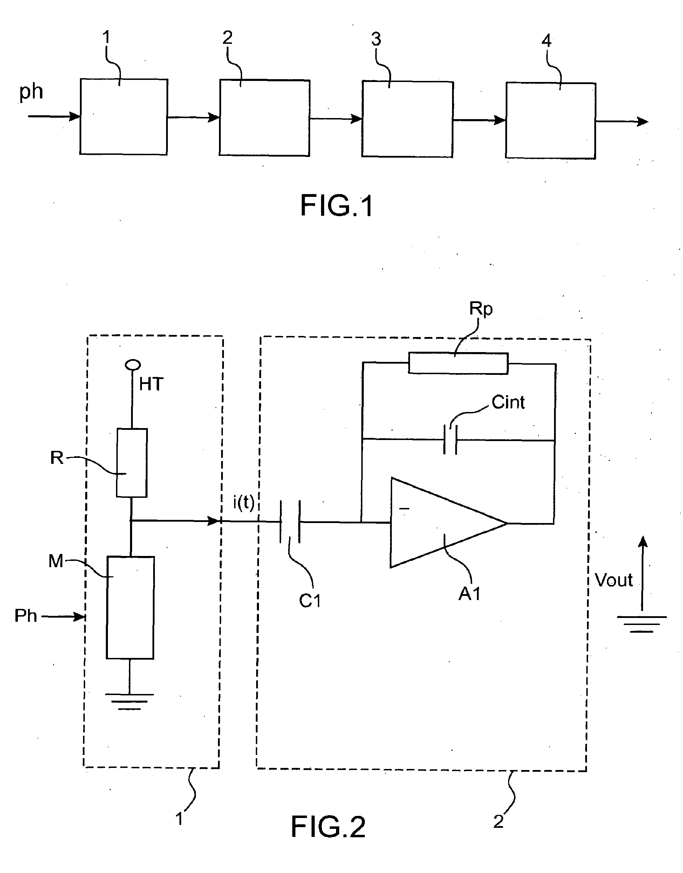

Un synoptique d'un système de détection de rayonnements électromagnétiques ionisants est représenté en figure 1. Un tel système est généralement constitué d'un détecteur à semi-conducteur 1 qui reçoit des photons incidents ph, d'un préamplificateur de charge 2 mesurant le signal délivré par le détecteur 1, d'une électronique de traitement 3 qui traite le signal délivré par le circuit électronique 2 et d'un circuit de conversion analogique-numérique 4 qui numérise les signaux délivrés par le système électronique 3 afin d'obtenir l'histogramme de ces signaux. Le spectre en énergie des photons ph incidents reçus peut-être obtenu à partir de cet histogramme.

Un système de détection de rayonnements électromagnétiques ionisants doit avoir, d'une part, une haute résolution en énergie et d'autre part une efficacité de détection élevée.

Les détecteurs à semi-conducteur répondent à ces deux critères. Les avantages de l'utilisation de semiconducteurs pour la détection de rayonnements électromagnétiques sont décrits dans la demande de brevet FR 2951037, déposée au nom du même demandeur. Les détecteurs à semi-conducteur, lorsqu'ils sont soumis à un rayonnement intense, produisent de très nombreuses impulsions par unité de temps. Ainsi, les systèmes de détection de rayonnements électromagnétiques ionisants qui utilisent les détecteurs à semi-conducteur doivent être munis d'une chaîne de spectrométrie rapide à fort taux de comptage.

On considère généralement qu'un taux de comptage est élevé au-delà de quelques 100 000 photons détectés par seconde (ou coups par seconde).

Les préamplificateurs de charge faible bruit les plus performants sont ceux utilisant un intégrateur de courant. La figure 2 illustre un tel montage associé au détecteur à semi-conducteur 1.

Le détecteur 1 comprend un élément en matériau semi-conducteur M et une résistance R qui relie l'élément M à une haute tension HT. Le circuit intégrateur de courant comprend une capacité C1, un amplificateur A1, une capacité Cint et une résistance Rp. La capacité C1 est montée sur l'entrée inverseuse de l'amplificateur A1 et la capacité Cint et la résistance Rp sont montées en parallèle entre l'entrée inverseuse et la sortie de l'amplificateur A1.

De manière schématique, lorsqu'un photon pénètre dans l'élément semi-conducteur M avec une énergie suffisante, il peut créer des porteurs dans le matériau. L'élément semi-conducteur M produit alors un courant de détection i(t) pendant le temps de détection du photon ph. Plus précisément, une impulsion de courant est générée pour chaque photon ph absorbé ayant une énergie suffisante.

Monté en sortie du détecteur 1, le préamplificateur de charge reçoit le courant i(t) et produit en réponse la tension Vout (t), donnée par :

$$Vout(t) = -\frac{1}{Cint} \cdot \int i(t)dt = -Q/Cint$$

où Q est la quantité de charge produite par le photon ph interagissant avec le matériau semi-conducteur.

En sortie du préamplificateur de charge, la tension Vout(t), sous forme d'impulsions de tension, est fugitive car le préamplificateur se décharge au-travers de la capacité Cint. Cette tension Vout(t) doit donc être rapidement sauvegardée après la disparition du courant de détection i(t). Parallèlement, la relaxation du préamplificateur de charge permet de faire face à de forts taux de comptage car la tension en sortie de celui-ci s'annule et, sans relaxation, le préamplificateur serait vite saturé.

La tension Vout(t) délivrée par le circuit électronique 2 correspond à la tension d'entrée du circuit électronique de traitement 3.

Pour pouvoir répondre aux forts taux de comptage, la demande de brevet FR2951037 propose un circuit de traitement 3 comprenant une ligne à retard Lr.

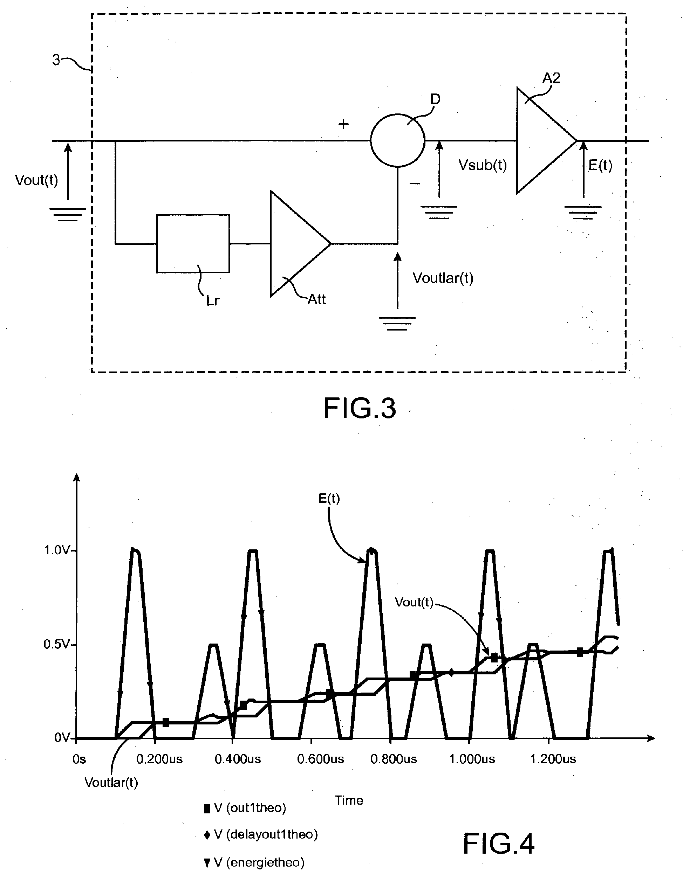

Un schéma d'un tel circuit électronique est illustré en figure 3.

La sortie Vout(t) du préamplificateur de charge 2 est directement reliée à un ensemble constitué d'une ligne à retard Lr, d'un atténuateur Att (gain inférieur à 1), d'un soustracteur D, et d'un amplificateur A2. La sortie de l'amplificateur A2 est directement reliée au circuit de conversion analogique-numérique 4. La ligne à retard Lr, montée en série avec l'atténuateur Att, a une première borne reliée à la sortie du préamplificateur de charge et une seconde borne reliée à l'entrée négative du soustracteur D. L'entrée positive du soustracteur D est directement reliée à la sortie du préamplificateur de charge.

Grâce à cet agencement, le signal Vout(t) issu du préamplificateur de charge est retardé d'un retard Δ par la ligne à retard. Le retard Δ est choisi supérieur au temps de montée du signal Vout(t) afin d'avoir en sortie du soustracteur, une impulsion de même amplitude que l'impulsion d'entrée, sans altération de l'information d'énergie.

La figure 4 représente en fonction du temps, la variation de la tension en sortie du préamplificateur de charge vout(t), de la tension en sortie de la ligne à retard voutlar(t) et de la tension en sortie de l'amplificateur A2, E(t).

Le soustracteur D soustrait la tension Voutlar(t) retardée à la tension Vout(t). Le signal vsub(t)= voutpa(t)- voutlar(t) qui résulte de cette soustraction est ensuite amplifié par l'amplificateur A2. Celui-ci délivre alors une impulsion de tension E(t) dont la hauteur est proportionnelle à l'impulsion produite aux bornes du détecteur, c'est-à-dire à l'énergie cédée par le photon ph au matériau semi-conducteur.

Cette impulsion de tension E(t) est ensuite numérisée par un convertisseur analogique-numérique 4. Les valeurs numériques ainsi obtenues sont fournies à un calculateur programmé pour identifier les valeurs d'énergie supérieures à un seuil d'énergie prédéterminée. Une fois les valeurs d'énergie identifiées, un algorithme calcule les valeurs correspondantes d'énergie des photons.

On comprend que le dispositif formé par le préamplificateur de charge 2 et le circuit de traitement 3 forme un dispositif de conversion d'impulsions de courant en impulsions de tension.

Avec l'utilisation de détecteurs à semi-conducteur, les taux de comptage peuvent être supérieurs à 10 millions de photons incidents par seconde ce qui nécessite de construire un dispositif de conversion d'impulsions de courant en impulsions de tension adapté.

Or, les lignes à retard Lr, intégrées dans les dispositifs de conversion d'impulsions de courant en impulsions de tension, comme les lignes à retard à transfert de charge, ne sont pas adaptées à de tels taux de comptage.

Elles présentent en effet un faible rapport signal sur bruit ainsi qu'une forte sensibilité aux dispersions technologiques et à l'environnement.

D'autre part, l'implémentation de telles lignes à retard, dans un dispositif de conversion d'impulsions de courant en impulsions de tension, nécessite l'utilisation d'un atténuateur Att comme illustré en figure 3.

L'atténuateur Att a pour fonction de compenser le pôle du préamplificateur de charge.

En effet, lorsque le pôle du préamplificateur de charge 2 n'est pas compensé, l'amplitude du signal vsub(t) présente un offset pour chaque impulsion de courant reçue par le préamplificateur de charge 2.

Ce phénomène est cumulatif lorsque les impulsions sont rapprochées, en particulier pour de forts taux de comptage. L'accumulation des offsets tend à saturer et donc à paralyser le dispositif de conversion d'impulsions de courant en impulsions de tension, et donc le système de détection de rayonnements électromagnétiques ionisants.

Le pôle du préamplificateur de charge est compensé quand le gain de l'atténuateur Att vaut $G = e^{-\Delta/RpCint}$. Compte tenu du calcul du terme exponentiel, ce gain, généralement compris entre 0,995 et 0,999, est difficile à régler et un tel atténuateur peut difficilement être réalisé en pratique. Les lignes à retard, telles que présentées dans la demande de brevet FR2951037, sont donc inadaptées pour de très forts taux de comptage.

L'objectif de la présente invention est de proposer un dispositif de conversion d'impulsions de courant en impulsions de tension qui fonctionne à très haute fréquence.

Un but subsidiaire de la présente invention est de proposer un détecteur de rayonnements électromagnétiques à semi-conducteur présentant un taux de comptage élevé et une grande précision.

**EXPOSÉ DE L'INVENTION**

Cet objectif est atteint par la présente invention qui est définie par un dispositif de conversion d'impulsions de courant en impulsions de tension comprenant :

- un circuit intégrateur comprenant un premier condensateur et une première résistance placés en parallèle entre la sortie et l'entrée inverseuse d'un amplificateur opérationnel, ladite entrée inverseuse dudit l'amplificateur opérationnel recevant lesdites impulsions de courant ;
- une ligne de retard recevant ladite sortie dudit circuit intégrateur et générant un retard ;
- un circuit soustracteur recevant sur une borne positive ladite sortie du circuit intégrateur et sur une borne négative la sortie de ladite ligne de retard; caractérisé en ce que ladite ligne de retard comprend au moins une cellule mémoire, ladite cellule mémoire comprenant:
- un premier et un second commutateurs en série entre ladite entrée et ladite sortie de ladite ligne de retard, ledit premier commutateur étant relié à ladite sortie dudit circuit intégrateur et ledit second commutateur étant relié à ladite borne négative dudit circuit soustracteur ;
- un second condensateur placé entre le noeud commun des deux commutateurs et un premier potentiel de référence ; et
- une seconde résistance placée entre le noeud commun dudit second condensateur (Ce) et dudit second commutateur, et placée à un second potentiel de référence ; et

le produit entre ladite première résistance et ladite première capacité étant égal au produit entre ladite seconde résistance et ladite seconde capacité.

Ce dispositif comprend en outre, des moyens logiques aptes à envoyer vers chacune des cellules mémoire successivement, un premier signal vers le premier commutateur pour le rendre passant et un second signal vers le second commutateur pour le rendre passant, le second signai étant en décalage temporel du premier signal et le décalage temporel étant défini en fonction du retard choisi.

Avantageusement, le second potentiel de référence est égal au potentiel continu de ladite entrée inverseuse dudit amplificateur opérationnel.

Le retard est choisi supérieur au temps de montée du signal en sortie du circuit intégrateur.

Ce dispositif de conversion d'impulsions de courant en impulsions de tension est intégrable dans un circuit intégré spécifique(ASIC). Avantageusement, le dispositif est réalisé dans une technologie CMOS.

L'invention concerne en outre un système de détection de rayonnements électromagnétiques ionisants, caractérisé en ce qu'il comporte un détecteur de rayonnements électromagnétiques ionisants adapté à recevoir des photons incidents et à émettre en sortie des impulsions de courant, un dispositif de conversion d'impulsions de courant en impulsions de tension selon l'une quelconque des revendications précédentes relié à la sortie dudit détecteur, et un convertisseur numérique analogique en sortie dudit dispositif de conversion d'impulsions de courant en impulsions de tension.

Le détecteur de rayonnements électromagnétiques ionisants peut-être un détecteur à semi-conducteur.

Enfin, le système de détection de rayonnements électromagnétiques ionisants selon l'invention peut être utilisé pour la détection d'explosifs dans des bagages.

## BRÈVE DESCRIPTION DES DESSINS

D'autres caractéristiques et avantages de l'invention apparaîtront à la lecture d'un mode de réalisation préférentiel de l'invention fait en référence aux figures jointes parmi lesquelles :

- la figure 1 illustre un synoptique d'un système de détection de rayonnements électromagnétiques ionisants commun de l'état de la technique ;
- la figure 2 illustre le montage d'un préamplificateur de charge associé à un détecteur de rayonnement dans le système de détection de rayonnements électromagnétiques ionisants de la figure 1 ;
- la figure 3 illustre un schéma d'un circuit électronique de traitement dans le système de détection de la figure 1 ;
- la figure 4 représente la variation en fonction du temps de la tension en sortie du préamplificateur de charge de la figure 2 et celle en sortie du circuit de traitement de la figure 3 ;
- la figure 5A illustre un schéma du dispositif de conversion d'impulsions de courant en impulsions de tension selon un premier mode de réalisation de l'invention ;
- la figure 5B illustre un schéma du dispositif de conversion d'impulsions de courant en impulsions de tension selon un second mode de réalisation de l'invention ;
- la figure 6A illustre un synoptique de la ligne à retard analogique à capacités commutées, intégrée dans le dispositif de conversion de la figure 5A ;
- la figure 6B illustre un synoptique de la ligne à retard analogique à capacités commutées, intégrée dans le dispositif de conversion de la figure 5B ;
- la figure 7 illustre les signaux obtenus en sortie de deux dispositifs de conversion d'impulsions de courant en impulsions de tension selon la figure 5A ;
- la figure 8 illustre un chronogramme des signaux de commande du dispositif de conversion d'impulsions selon la figure 5A ;
- la figure 9 illustre un synoptique d'un système de détection de rayonnements électromagnétiques ionisants utilisant le dispositif de conversion d'impulsions de la figure 5A.

## EXPOSÉ DÉTAILLÉ DE MODES DE RÉALISATION PARTICULIERS

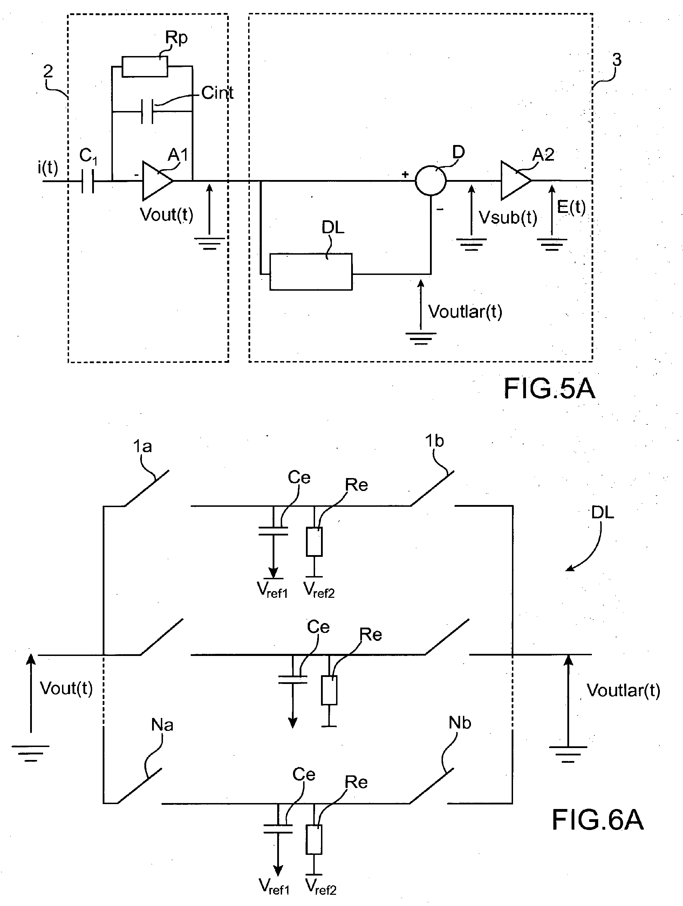

La figure 5A illustre un schéma du dispositif de conversion d'impulsions de courant en impulsions de tension selon un premier mode de réalisation de l'invention. Le dispositif comprend un préamplificateur de charge 2 et une électronique de traitement 3.

Le dispositif de la figure 5A comporte un préamplificateur de charge 2 monté en intégrateur. Le circuit intégrateur de courant comprend une capacité C1, un amplificateur A1, une capacité Cint et une résistance Rp. La capacité C1 est montée sur l'entrée inverseuse de l'amplificateur A1 et la capacité Cint et la résistance Rp sont montées en parallèle entre l'entrée inverseuse et la sortie de l'amplificateur A1.

En réponse à une impulsion de courant i(t), le préamplificateur de charge 2 produit une impulsion de tension Vout(t). La sortie du préamplificateur de charge 2 est directement reliée à un ensemble constitué d'une ligne à retard DL, de moyens de soustraction D, et d'un amplificateur A2.

La ligne à retard DL a une première borne reliée à la sortie du préamplificateur de charge 2 et une seconde borne reliée à l'entrée négative des moyens de soustraction D. L'entrée positive des moyens de soustraction D est directement reliée à la sortie du préamplificateur de charge 2. Les moyens de soustraction D peuvent par exemple être réalisés sous la forme d'un amplificateur différentiel, de manière connue en soi.

Le dispositif selon l'invention est remarquable en ce qu'il comporte une ligne à retard à perte contrôlée DL, réalisée au moyen de N capacités commutées, avec $N \geq 1$, et N éléments résistifs montés en parallèle. Les N capacités, commutées de façon séquentielle et cyclique, constituent une mémoire de N échantillons successifs du signal.

Comme nous le verrons plus loin, le dispositif est auto-adaptatif au sens où il s'adapte automatiquement au retard de la ligne utilisée grâce à la présence des éléments résistifs.

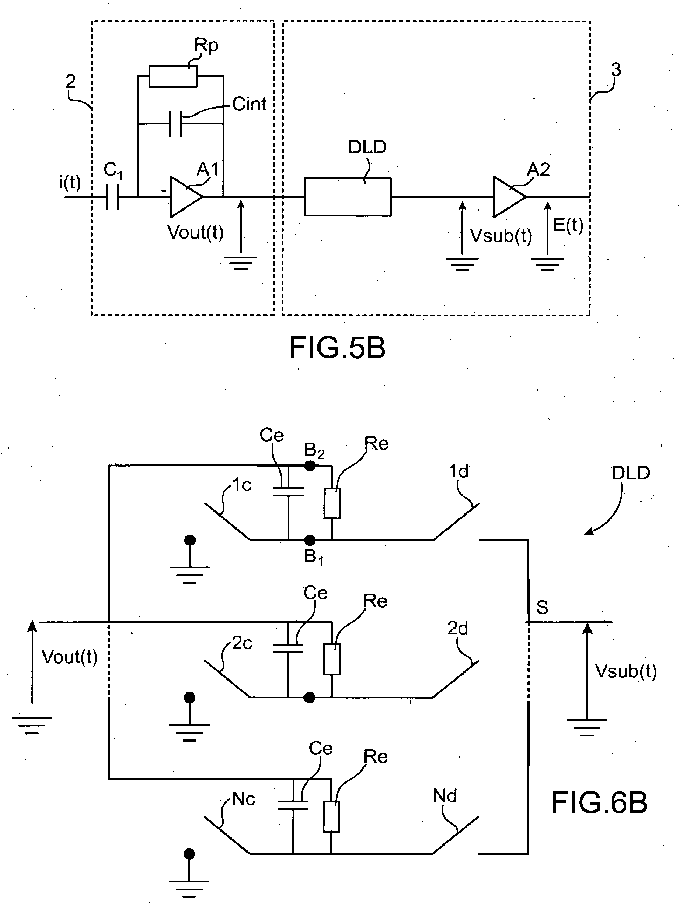

La Fig. 5B illustre un schéma du dispositif de conversion d'impulsions de courant en impulsions de tension selon un second mode de réalisation de l'invention. Les éléments portant les mêmes signes de référence qu'en Fig. 5A sont identiques à ceux déjà décrits précédemment.

Le dispositif de conversion d'impulsions de la Fig. 5B diffère de celui de la Fig. 5A en ce qu'il comprend une ligne à retard DLD intégrant des moyens de soustraction, comme expliqué plus loin en relation avec la Fig. 6B. La sortie S de la ligne à retard DLD est reliée directement à l'entrée de l'amplificateur A2.

De même que dans le premier mode de réalisation, la ligne à retard DLD, est à perte contrôlée et est réalisée au moyen de N capacités commutées, avec $N \geq 1$, et N éléments résistifs montés en parallèle, les N capacités, commutées de façon séquentielle et cyclique, constituant là encore une mémoire de N échantillons successifs du signal.

La figure 6A donne un synoptique d'un mode de réalisation de la ligne à retard DL utilisée dans la figure 5A. La ligne à retard DL est réalisée par la mise en parallèle de N étages comprenant chacun une cellule mémoire élémentaire.

La ligne à retard DL reçoit en entrée le signal Vout(t) provenant du préamplificateur de charge 2 et produit un signal retardé Voutlar(t).

Chaque cellule mémoire élémentaire se compose d'un premier commutateur 1a, 2a, ...Na et d'un second commutateur 1b, 2b, ...Nb en série entre l'entrée et la sortie de la ligne de retard, d'un condensateur Ce placé entre le noeud commun des deux commutateurs et un premier potentiel de référence Vref1. En outre, une résistance Re est placée entre le noeud commun des deux commutateurs et un second potentiel de référence Vref2. On réalise ainsi une Ligne à Retard Analogique à Capacités Commutées (LARACC).

On comprend que le retard de la ligne est essentiellement donné par la différence entre les instants de commutation des commutateurs 1a et 1b, 2a et 2b,...,Na et Nb.

On distinguera les commutateurs d'écriture la,2a,...Na reliés à la sortie du circuit intégrateur 2 et les commutateurs de lecture 1b, 2b, ...Nb reliés à une première entrée du soustracteur D.

Les cellules mémoire sont identiques. Ainsi, la valeur de la résistance et la valeur de la capacité sont les mêmes pour chacune des cellules mémoire.

Dans chaque cellule mémoire, la résistance Re agit comme un élément de décharge de la capacité Ce. Re est choisie pour que la constante de temps *Re.Ce* soit la même que *Rp. Cint,* autrement dit que la vitesse de décharge de la capacité Ce soit la même que la vitesse de décharge de la capacité Cint. Dès lors, le pôle du préamplificateur de charge 2 est compensé et le dispositif de conversion s'adapte automatiquement au retard quelque soit le retard choisi, tant que celui-ci est supérieur au temps de montée du signal Vout(t). La présence d'un atténuateur dans la boucle de retard n'est donc plus nécessaire. Dans chaque cellule mémoire, la résistance Re est placée entre le noeud commun à la capacité Ce et au commutateur de lecture. Elle est en outre, reliée à un second potentiel de référence Vref2. La résistance Re est prévue pour compenser, de manière simple et efficace, le pôle du préamplificateur de charge.

Plus précisément, le fonctionnement et le choix de la résistance Re va être décrit avec le fonctionnement d'une seule cellule mémoire selon l'invention. On comprendra que cet exemple est généralisable aux autres cellules mémoire dans le cas où N>1.

Lorsque le commutateur d'écriture de la cellule mémoire est fermé, la cellule mémoire reçoit la tension Vout(t). La capacité Ce se charge.

A l'ouverture du commutateur d'écriture de la cellule mémoire, c'est-à-dire à l'instant de la prise d'échantillon, la capacité Ce commence à se décharger à travers Re.

Afin de réaliser la compensation du pôle du préamplificateur de charge 2, il faut qu'au moment de la lecture, la tension mémorisée sur la capacité Ce ait perdu la même quantité que celle aux bornes de la capacité Cint.

Il faut donc que la capacité Ce se soit déchargée avec la même constante de temps $\tau$. Cette condition est remplie lorsque *Rp.Cint = Re.Ce*.

Avantageusement, les composants Rp et Re d'une part et Cint et Ce d'autre part seront appariés afin de s'affranchir des variations technologiques et environnementales.

Dans un mode de réalisation préféré de l'invention, le potentiel Vref2 est mis au même potentiel continu que l'entrée inverseuse du préamplificateur de charge 2. A cet effet, on pourra relier l'électrode de Re, qui n'est pas reliée au noeud commun à la capacité Ce et au commutateur de lecture, à un amplificateur opérationnel bouclé sur lui-même. Ainsi, on empêche la circulation d'un courant permanent qui vient fausser les charges et les décharges des capacités. L'intérêt de cette caractéristique apparaît à cadence élevée.

La Fig. 6B représente un synoptique d'un mode de réalisation de la ligne à retard DLD utilisée dans la figure 5B. La ligne à retard DLD est réalisée par la mise en parallèle de $N \geq 1$ étages comprenant chacun une cellule mémoire élémentaire.

Plus précisément, chaque cellule mémoire élémentaire comprend une capacité Ce, montée en parallèle avec une résistance Re, entre un premier noeud commun B1 et un second noeud commun B2. Les valeurs de Re et Ce sont choisies de manière à ce que *Rp.Cint = Re.Ce*.

Chaque cellule mémoire est équipée en outre d'un commutateur d'écriture et un commutateur de lecture. Les commutateurs d'écriture des différentes cellules sont indiqués par 1c, 2c,...Nc et les commutateurs de lecture sont indiqués par 1d,2d,...,Nd.

Pour chaque cellule, le premier noeud commun (B1) est relié, d'une part, à un commutateur d'écriture (1c,...,Nc) et, d'autre part, à un commutateur de lecture (1d,...,Nd). Le second noeud commun (B2) de la cellule est relié à la sortie du préamplificateur de charge 2. Le commutateur d'écriture connecte, lorsqu'il est passant, le premier noeud commun à la masse. Le commutateur de lecture, quant à lui, connecte, lorsqu'il est passant, le premier noeud commun B1 à la sortie S de la ligne à retard.

On notera que les seconds noeuds communs B2 des différentes cellules élémentaires sont tous reliés directement à la sortie du préamplificateur de charge 2 alors que les premiers noeuds communs des différentes cellules élémentaires sont reliés, à travers leurs commutateurs de lecture respectifs, à la sortie S de la ligne à retard DLD.

Dans une étape d'écriture de la cellule élémentaire, le commutateur d'écriture est rendu passant et le commutateur de lecture est mis dans un état de haute impédance. La capacité Ce se charge alors à une tension $V_{out}(t_1)$ où $t_1$ est la fin de l'étape d'écriture.

A l'ouverture du commutateur d'écriture, la cellule mémoire est déconnectée à la fois de la sortie du préamplificateur de charge 2 et la sortie S. La capacité Ce se décharge alors très lentement à travers la résistance Re avec la même constante $\tau$ que celle du préamplificateur de charge. Si l'on note $V_c(t)$ la tension restante entre les bornes de la capacité, la tension sur la seconde borne commune est égale à $V_{out}(t) - Vc(t)$, c'est-à-dire à la perte de décharge près, à $Vout(t) - V_{out}(t_1)$, où $V_{out}(t)$ est la tension instantanée à la sortie du préamplificateur de charge.

Dans une étape de lecture, le commutateur de lecture est rendu passant alors que le commutateur d'écriture reste en haute impédance. La tension sur la sortie S est alors égale à $V_{out}(t_2) - V_{out}(t_1)$ où $t_2$ est l'instant de lecture.

Le montage particulier de la cellule mémoire permet d'obtenir ici directement la différence de tension $V_{out}(t_2) - V_{out}(t_1)$ à l'étape de lecture, le passage du commutateur d'écriture en haute impédance assurant la soustraction de la tension mémorisée $V_{out}(t_1)$ à la tension d'entrée $V_{out}(t)$.

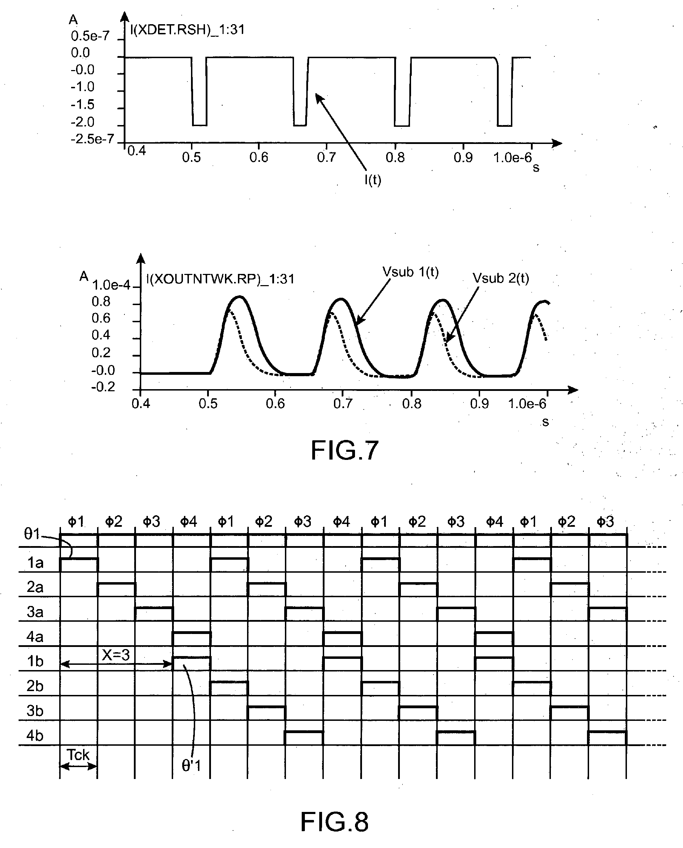

La figure 7 illustre les signaux obtenus en sortie de deux dispositifs de conversion d'impulsions de courant en impulsions de tension selon la figure 5A.

En réponse à une impulsion i(t), le premier dispositif de conversion d'impulsions de courant en impulsions de tension produit un signal vsub1(t) et le second dispositif de conversion d'impulsions de courant en impulsions produit un signal vsub2(t).

Ces signaux, vsub1(t) et vsub2(t), mesurés par un oscilloscope, ne présentent pas d'offsets après chaque impulsion, même lorsque les impulsions sont rapprochées. La saturation du dispositif de conversion d'impulsions de courant en impulsions de tension est ainsi évitée et la mesure de l'énergie des photons ph reçus par le détecteur 1 est donc extrêmement précise.

Un autre avantage de la conception de la ligne à retard DL, telle qu'illustrée en figure 5A, est d'éviter une dégradation du signal puisqu'il n'y a pas de transfert de charge entre les cellules mémoire, contrairement au principe de fonctionnement des technologies utilisées dans l'art antérieur, telles que les lignes à retard BBD (Acronyme de bucket-brigade device).

La ligne à retard DL selon l'invention est donc une ligne à retard à perte contrôlée adaptable dans un dispositif de conversion d'impulsions de courant en impulsions de tension dans lequel la fréquence d'apparition des impulsions de courant est très élevée.

Le fonctionnement de la ligne à retard DL va maintenant être décrit en relation avec la figure 5A et la figure 6. L'homme du métier comprendra que le fonctionnement de la ligne à retard DLD est identique et une description séparée n'en sera donc pas faite ici.

La ligne à retard DL peut être réalisée avec une seule cellule mémoire élémentaire, c'est-à-dire avec N=1.

Cependant, de manière privilégiée, le signal sera sur-échantillonné afin d'augmenter le rapport signal sur bruit.

Le principe à la base du fonctionnement de la ligne à retard DL est que l'échantillonnage du signal retardé est obtenu par la lecture du signal en retard de l'écriture.

L'écriture est faite sur la capacité Ce de la première cellule mémoire pendant une période θ1 durant laquelle le commutateur d'écriture la est passant et les autres commutateurs d'écriture ouverts, sur la capacité Ce de la deuxième cellule mémoire pendant une période θ2 durant laquelle le commutateur d'écriture 2a est passant et les autres commutateurs d'écriture ouverts et ainsi de suite jusqu'à la Nième capacité. Le cycle est alors complet et recommence avec la capacité 1.

Chaque période θ1,θ2,...,θN est non recouvrante avec les périodes antérieures et postérieures afin d'éviter tout conflit entre les cellules mémoire.

La lecture suit exactement le même processus que l'écriture. Ainsi, la lecture est faite avec la décharge de la capacité Ce de la première cellule mémoire pendant une période θ1' durant laquelle le commutateur de lecture 1b est passant et les autres commutateurs d'écriture ouverts, avec la décharge de la capacité Ce de la deuxième cellule mémoire pendant une période θ2' durant laquelle le commutateur de lecture 2b est passant et les autres commutateurs de lecture ouverts et ainsi de suite jusqu'à la Nième capacité. Le cycle est alors complet et recommence avec la capacité 1.

Chaque période θ1', θ2',...θN', est non recouvrante avec les périodes antérieures et postérieures afin d'éviter tout conflit entre les cellules mémoire.

Pour une même cellule élémentaire, la période durant laquelle le commutateur de lecture est passant est décalée temporairement, d'un décalage temporel noté x, de la période durant laquelle le commutateur d'écriture est passant. Les commutateurs de lecture sont donc commutés séquentiellement après les commutateurs d'écriture.

La commande des périodes est effectuée de la façon suivante :

Un séquenceur génère $2^n$ phases non-recouvrantes de durée Tck. Chaque phase de contrôle est retardée de la précédente d'un retard égal à Tck. Le retard Tck provient d'une horloge de fréquence fck, comme par exemple une horloge à quartz.

Le compteur est par exemple un compteur binaire de n bits auquel est associé un décodeur n vers $2^n$.

Avantageusement, on choisira n de sorte que $2^n = N$ afin de mettre en oeuvre une logique binaire simple. Cette égalité sera utilisée dans la suite de la description. On comprendra alors que le décalage temporel x peut être compris entre 1 et N périodes.

Le compteur est avantageusement synchrone puisque le système selon l'invention est destiné à un fonctionnement à fréquence élevée.

Le séquenceur se compose d'un compteur relié à une base de temps, d'un décodeur en sortie du compteur et de bascules RS en sortie du décodeur.

Les bascules RS assurent le non-recouvrement des $2^n$ phases.

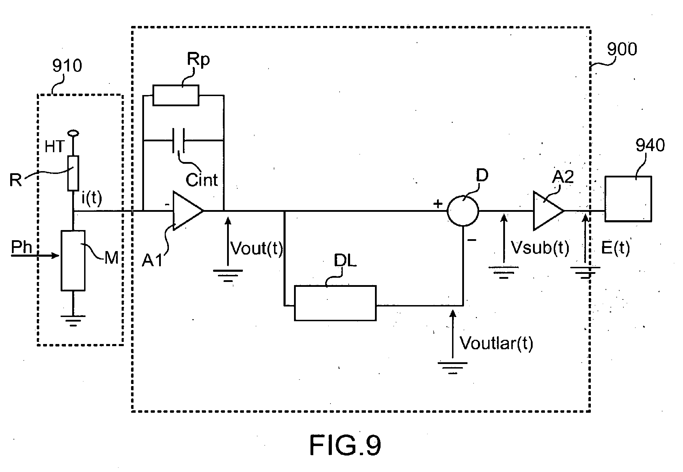

La chronologie des périodes de contrôle va maintenant être décrite en relation avec la figure 9, qui illustre une ligne à retard DL selon la figure 6 dans laquelle N=4.

Cette ligne comporte 4 commutateurs d'écriture 1a,2a,3a,4a et 4 commutateurs de lecture 1b,2b,3b,4b. Les chronogrammes représentés en figure 8 représentent l'évolution des commutateurs de lecture et d'écriture en fonction d'un cycle de conversion.

Pour la première cellule élémentaire, la période $\theta 1$ durant laquelle le commutateur d'écriture 1a est passant est égale à Tck. Le début de la période $\theta 1$ correspond au front montant de la première phase d'horloge $\varphi 1$ et la fin de la période $\theta 1$ correspond au front descendant de la première phase d'horloge 1. Ce principe est valable pour les 3 autres cellules élémentaires.

Pour la première cellule élémentaire, la période $\theta 1"$ durant laquelle le commutateur de lecture 1b est passant est égale à Tck et le début de la période $\theta 1'$ correspond au front montant de la première phase d'horloge $\varphi 1$ décalée de 3 périodes dans cet exemple. La fin de la période $\theta 1'$ correspond au front descendant de la première phase d'horloge $\varphi 1$ décalée de 3 périodes. Ce principe est valable pour les 3 autres cellules élémentaires.

Dans le dispositif de conversion selon l'invention, la valeur du décalage temporel x peut être obtenue par un aiguillage des phases d'horloge en retard sur les commutateurs de lecture. La valeur de x est donc dépendante de la fréquence fck de l'horloge ainsi que de l'aiguillage choisi. L'aiguillage des phases d'horloge est réalisé au moyen d'un circuit d'aiguillage.

Avantageusement, ce circuit d'aiguillage est contrôlable afin de faire varier la valeur du décalage x.

Le séquenceur, l'horloge et le circuit d'aiguillage constituent les moyens logiques de commande du dispositif de conversion selon l'invention.

Le retard $\Delta$ généré par la ligne à retard DL correspond à l'addition d'un temps de propagation fixe d'environ 5ns +/- 1ns et du décalage temporel x entre l'écriture et la lecture de la ligne à retard DL.

Le retard est donc défini par la formule suivante :

$$\Delta = tpd + x$$

avec *tpd* le temps de propagation égal à 5 ns +-1ns, et x le décalage temporel.

De cette manière, le retard peut être réglé en changeant la fréquence d'horloge fck et/ou le contrôle du circuit d'aiguillage.

Le retard $\Delta$ est nécessairement supérieur au temps de montée du signal Vout(t) afin d'avoir en sortie du soustracteur, une impulsion de même amplitude que l'impulsion d'entrée, sans altération de l'information d'énergie.

Le dispositif de conversion tel qu'illustré en figure 5A (ou figure 5B) peut être réalisé en électronique discrète avec des composants du commerce.

Avantageusement, un filtre à temps continu peut être disposé en sortie de la ligne à retard DL (ou DLD). Ce filtre à temps continu, par exemple du type Butterworth ou Chebychev, permet de diminuer davantage le bruit de commutation.

De manière préférentielle, le dispositif selon l'invention est intégrable en micro-électronique et le dispositif est adapté à l'intégration micro-électronique dans une technologie CMOS qui présente l'avantage d'être peu coûteuse et permet d'obtenir des dispositifs avec des performances remarquables, notamment en terme de consommation électrique.

Les commutateurs sont de préférence des transistors MOSFET et dans ce cas, l'augmentation de la valeur de capacité Ce permet de diminuer le bruit en kT/C.

De manière préférentielle, on choisira une implantation en technologie courante CMOS $0,35\mu m$. Réalisé dans une telle technologie, le dispositif est alors intégrable dans un circuit spécifique ou ASIC (acronyme de l'anglais : « Application Specific Integrated Circuit »).

Le dispositif peut alors répondre aux contraintes suivantes :

- encombrement cohérent avec l'intégration micro-électronique, c'est-à-dire inférieur à 1 mm² ;
- faible sensibilité aux variations technologiques afin de limiter les dispersions d'un circuit à l'autre ;
- faible sensibilité aux variations environnementales (température, tension d'alimentation, etc.) ;
- bruit faible, de l'ordre de $100\mu V$ max ;
- dynamique élevée, de l'ordre de 1V ;
- faible consommation, de l'ordre de 20 mW maximum.

De préférence, les moyens logiques qui permettent de contrôler là commutation des commutateurs sont implémentés dans l'ASIC. L'horloge est externe au circuit ASIC sur lequel est implanté le dispositif de conversion d'impulsions de courant en impulsions de tension.

Un exemple de réalisation du dispositif selon la figure 5A va maintenant être décrit. Dans cet exemple, la ligne à retard DL est composée de 16 capacités et d'un compteur synchrone 4 bits piloté par une horloge de période T.

Les valeurs caractéristiques choisies sont :

Tck =1/fck = 5ns ou 10 ns

Cint = 50fF ; Rp = 10MOhm d'où $\tau$ =500ns

avec Ce = 1pF, il vient Re = 500kOhm.

Le choix de la valeur Ce = 1pF permet d'obtenir un bruit en kT/C égal à 130e-, négligeable dans la somme quadratique vis-à-vis de la charge équivalente de bruit du préamplificateur de charge, comprise entre 350e- et 650e- et la consommation mesurée pour une fréquence d'horloge f=200MHz est inférieure à 20mW.

La configuration du circuit d'aiguillage permet, avec les valeurs choisies d'obtenir des retards allant de 25ns à 50 ns avec une période d'horloge de 5 ns. En augmentant la période d'horloge à 10 ns, le dispositif de conversion ainsi réalisé permet d'obtenir des retards allant de 45 ns à 95 ns. Il est possible de produire des retards beaucoup plus longs en augmentant la période d'horloge et/ou en modifiant la configuration du dispositif d'aiguillage.

Dans cet exemple, le dispositif est adapté à l'intégration micro-électronique où son encombrement $400\times600\mu m^2$ dans une technologie courante CMOS $0,35\mu m$ est cohérent avec celui d'autres fonctions.

Dans un mode de réalisation, le dispositif de conversion décrit ci-avant est intégré dans système de détection de rayonnements électromagnétiques ionisants.

Plus précisément, la figure 9 illustre un synoptique du système de détection de rayonnements électromagnétiques ionisants selon un mode de réalisation de l'invention.

Selon l'invention, le système comporte un détecteur à semi-conducteur 910. Le détecteur 910 comprend un élément en matériau semi-conducteur M, comme, par exemple, un détecteur à CdZnTe, ou CdTe :Cl, ou encore CdTe :In, et une résistance R qui relie l'élément M à une haute tension HT. La sortie du détecteur à semi-conducteur 910 est reliée à un dispositif de conversion d'impulsions de courant en impulsions de tension 900 tel que décrit en relation avec la figure 5A.

Un convertisseur analogique-numérique 940 est connecté à la sortie du dispositif de conversion d'impulsions de courant en impulsions de tension 900 et reçoit les impulsions de tension E(t).

De manière préférentielle, le convertisseur analogique-numérique 940 et le compteur du dispositif de conversion 900 sont synchronisés par la même horloge.

L'échantillonnage des signaux au niveau du convertisseur analogique-numérique 940 est par conséquent facilité.

L'homme du métier comprendra qu'un système de détection de rayonnements électromagnétiques ionisants peut être réalisé de la même façon à partir du dispositif de conversion d'impulsions de courant en impulsion de tension illustré en Fig. 5B.

Le système de détection de rayonnements électromagnétiques ionisants trouvera application notamment à la mesure par spectrométrie de tout rayonnement ionisant, et tout particulièrement, le rayonnement X ou le rayon gamma, notamment dans les cas où ledit rayonnement est intense.

Il peut ainsi être utilisé pour la détection d'explosifs dans des bagages. Outre le contrôle de bagage, ce dispositif pourra trouver application dans le domaine nucléaire, comme par exemple la mesure de l'activité de déchets ou de combustible.

**Revendications**

1. Dispositif de conversion d'impulsions de courant en impulsions de tension comprenant :

   - un circuit intégrateur (2) comprenant un premier condensateur (Cint) et une première résistance (Rp) placés en parallèle entre la sortie et l'entrée inverseuse d'un amplificateur opérationnel (A1), ladite entrée inverseuse dudit l'amplificateur opérationnel (A1) recevant lesdites impulsions de courant ;
   - une ligne à retard (DL) recevant ladite sortie (vout) dudit circuit intégrateur et générant un retard ($\Delta$) ; *
   **caractérisé en ce que** ladite ligne à retard (DL) comprend une pluralité de cellules mémoire, chaque cellule mémoire comprenant :
   - un second condensateur (Ce) et une seconde résistance (Re) montés en parallèle, le produit de ladite première résistance (Rp) et ladite première capacité (Cint) étant égal au produit de ladite seconde résistance (Re) et ladite seconde capacité (Ce) ;
   - un commutateur d'écriture (1a,..Na) connecté à un premier noeud commun au second condensateur et à la seconde résistance, adapté à charger le second condensateur à partir de la sortie du circuit intégrateur, lorsqu'il est passant et à mémoriser la tension aux bornes du condensateur lorsqu'il est en haute impédance ;
   - un commutateur de lecture (1b,...,Nb), connecté au premier noeud commun et permettant de lire la tension de ce noeud lorsque le commutateur de lecture est passant ;

   le dispositif de conversion comprenant en outre des moyens de soustraction (D) adaptés à soustraire la tension mémorisée aux bornes du condensateur à la tension de sortie du circuit intégrateur, et à fournir la différence de tension ainsi obtenue.

2. Dispositif de conversion d'impulsions de courant en impulsions de tension selon la revendication 1, **caractérisé en ce que** le second condensateur et la seconde résistance sont connectés à un second noeud commun, relié à la sortie du circuit intégrateur, et que le commutateur d'écriture connecte le premier noeud commun à la masse lorsqu'il est passant.

3. Dispositif de conversion d'impulsions de courant en impulsions de tension selon la revendication 1, **caractérisé en ce que** le commutateur d'écriture connecte le premier noeud commun à la sortie du circuit intégrateur lorsqu'il est passant, et que le commutateur de lecture connecte le premier noeud commun à une première entrée négative des moyens de soustraction lorsqu'il est passant, la sortie du circuit intégrateur étant connectée à une seconde entrée négative des moyens de soustraction.

4. Dispositif de conversion d'impulsions de courant en impulsions de tension selon la revendication 3, **caractérisée en ce que** le second condensateur est placé entre le premier noeud commun et un premier potentiel de référence (Vref1) et que la seconde résistance est placée entre le premier noeud commun et un second potentiel de référence (Vref2).

5. Dispositif de conversion d'impulsions de courant en impulsions de tension selon la revendication 1, **caractérisé en ce qu'**il comprend, en outre, des moyens logiques aptes à envoyer vers chacune desdites cellules mémoire successivement, un premier signal vers ledit commutateur d'écriture et un second signal vers ledit commutateur de lecture, ledit second signal étant en décalage temporel dudit premier signal et ledit décalage temporel (x) étant défini en fonction du retard ($\Delta$) choisi.

6. Dispositif de conversion d'impulsions de courant en impulsions de tension selon la revendication 4, **caractérisé en ce que** ledit second potentiel de référence (Vref2) est égal au potentiel continu de ladite entrée inverseuse dudit amplificateur opérationnel (A1).

7. Dispositif de conversion d'impulsions de courant en impulsions de tension selon l'une quelconque des revendications précédentes, **caractérisé en ce que** le retard ($\Delta$) est choisi supérieur au temps de montée du signal en sortie du circuit intégrateur (vout).

8. Dispositif de conversion d'impulsions de courant en impulsions de tension selon l'une quelconque des revendications précédentes, **caractérisé en ce qu'**il est intégrable dans un circuit intégré spécifique(ASIC).

9. Dispositif de conversion d'impulsions de courant en impulsions de tension selon l'une quelconque des revendications précédentes, **caractérisé en ce qu'**il est réalisé dans une technologie CMOS.

10. Système de détection de rayonnements électromagnétiques ionisants, **caractérisé en ce qu'**il comporte un détecteur de rayonnements électromagnétiques ionisants (910) adapté à recevoir des photons incidents (ph) et à émettre en sortie des impulsions de courant, un dispositif de conversion d'impulsions de courant en impulsions de tension (900) selon l'une quelconque des revendications précédentes relié à la sortie dudit détecteur (1), et un convertisseur numérique analogique (940) en sortie dudit dispositif de conversion d'impulsions de courant en impulsions de tension.

11. Système de détection de rayonnements électromagnétiques ionisants selon la revendication 10, **caractérisé en ce que** ledit détecteur de rayonnements électromagnétiques ionisants (910) est un détecteur à semi-conducteur.

12. Utilisation d'un système de détection de rayonnements électromagnétiques ionisants selon la revendication 10 ou 11 pour la détection d'explosifs dans des bagages.

**Patentansprüche**

1. Vorrichtung zur Umwandlung von Strompulsen in Spannungspulse, umfassend:

- eine Integratorschaltung (2), umfassend einen ersten Kondensator (Cint) und einen ersten Widerstand (Rp), die parallel zwischen dem Ausgang und dem invertierenden Eingang eines Operationsverstärkers (A1) platziert sind, wobei der invertierende Eingang des Operationsverstärkers (A1) die Strompulse empfängt;
- eine Verzögerungsleitung (DL), die die Ausgabe (vout) der Integratorschaltung empfängt und eine Verzögerung ($\Delta$) generiert;

**dadurch gekennzeichnet, dass** die Verzögerungsleitung (DL) eine Mehrzahl von Speicherzellen umfasst, wobei jede Speicherzelle umfasst:

- einen zweiten Kondensator (Ce) und einen zweiten Widerstand (Re), die parallel montiert sind, wobei das Produkt aus dem ersten Widerstand (Rp) und der ersten Kapazität (Cint) gleich ist dem Produkt aus dem zweiten Widerstand (Re) und der zweiten Kapazität (Ce);
- einen Schreibschalter (1a, ... Na), der an einem ersten gemeinsamen Knoten an den zweiten Kondensator und an den zweiten Widerstand angeschlossen und dazu ausgelegt ist, den zweiten Kondensator ausgehend von der Ausgabe der Integratorschaltung aufzuladen, wenn er leitend ist, und die Spannung an den Anschlüssen des Kondensators zu speichern, wenn er auf hoher Impedanz ist;
- einen Leseschalter (1b, ... Nb), der an den ersten gemeinsamen Knoten angeschlossen ist und es erlaubt, die Spannung dieses Knotens auszulesen, wenn der Leseschalter leitend ist;

wobei die Umwandlungsvorrichtung ferner Subtraktionsmittel (D) umfasst, die dazu ausgelegt sind, die an den Anschlüssen des Kondensators gespeicherte Spannung von der Ausgangsspannung der Integratorschaltung zu subtrahieren und die derart erhaltene Spannungsdifferenz auszugeben.

2. Vorrichtung zur Umwandlung von Strompulsen in Spannungspulse nach Anspruch 1, **dadurch gekennzeichnet, dass** der zweite Kondensator und der zweite Widerstand an einen zweiten gemeinsamen Knoten angeschlossen sind, der mit dem Ausgang der Integratorschaltung verbunden ist, und dass der Schreibschalter den ersten gemeinsamen Knoten mit der Masse verbindet, wenn er leitend ist.

3. Vorrichtung zur Umwandlung von Strompulsen in Spannungspulse nach Anspruch 1, **dadurch gekennzeichnet, dass** der Schreibschalter den ersten gemeinsamen Knoten mit dem Ausgang der Integratorschaltung verbindet, wenn er leitend ist, und dass der Leseschalter den ersten gemeinsamen Knoten mit einem ersten negativen Eingang der Subtraktionsmittel verbindet, wenn er leitend ist, wobei der Ausgang der Integratorschaltung an einen zweiten negativen Eingang der Subtraktionsmittel angeschlossen ist.

4. Vorrichtung zur Umwandlung von Strompulsen in Spannungspulse nach Anspruch 3, **dadurch gekennzeichnet, dass** der zweite Kondensator zwischen dem ersten gemeinsamen Knoten und einem ersten Referenzpotenzial (Vref1) angeordnet ist, und dass der zweite Widerstand zwischen dem ersten gemeinsamen Knoten und einem zweiten Referenzpotenzial (Vref2) angeordnet ist.

5. Vorrichtung zur Umwandlung von Strompulsen in Spannungspulse nach Anspruch 1, **dadurch gekennzeichnet, dass** sie ferner Logikmittel umfasst, die dazu ausgelegt sind, an jede der Speicherzellen nacheinander ein erstes Signal an den Schreibschalter und ein zweites Signal an den Leseschalter zu schicken, wobei das zweite Signal zeitlich von dem ersten Signal versetzt ist, und der zeitliche Versatz (x) als Funktion der gewählten Verzögerung (Δ) definiert ist.

6. Vorrichtung zur Umwandlung von Strompulsen in Spannungspulse nach Anspruch 4, **dadurch gekennzeichnet, dass** das zweite Referenzpotenzial (Vref2) gleich dem kontinuierlichen Potenzial des invertierenden Eingangs des Operationsverstärkers (A1) ist.

7. Vorrichtung zur Umwandlung von Strompulsen in Spannungspulse nach einem der vorhergehenden Ansprüche, **dadurch gekennzeichnet, dass** die Verzögerung (Δ) größer gewählt ist als die Anstiegszeit des Signals am Ausgang der Integratorschaltung (vout).

8. Vorrichtung zur Umwandlung von Strompulsen in Spannungspulse nach einem der vorhergehenden Ansprüche, **dadurch gekennzeichnet, dass** sie in eine spezifische integrierte Schaltung (ASIC) integrierbar ist.

9. Vorrichtung zur Umwandlung von Strompulsen in Spannungspulse nach einem der vorhergehenden Ansprüche, **dadurch gekennzeichnet, dass** sie in einer CMOS-Technologie realisiert ist.

10. System zur Erfassung von ionisierenden elektromagnetischen Strahlen, **dadurch gekennzeichnet, dass** es einen Detektor für ionisierende elektromagnetische Strahlen (910) umfasst, der dazu ausgelegt ist, einfallende Photonen (ph) zu empfangen und am Ausgang Strompulse zu emittieren, eine Vorrichtung zur Umwandlung von Strompulsen in Spannungspulse (900) nach einem der vorhergehenden Ansprüche, die mit dem Ausgang des Detektors (1) verbunden ist, sowie einen Digital/Analog-Wandler (940) am Ausgang der Vorrichtung zur Umwandlung von Strompulsen in Spannungspulse.

11. System zur Erfassung von ionisierenden elektromagnetischen Strahlen nach Anspruch 10, **dadurch gekennzeichnet, dass** der Detektor für ionisierende elektromagnetische Strahlen (910) ein Halbleiterdetektor ist.

12. Verwendung eines Systems zur Erfassung von ionisierenden elektromagnetischen Strahlen nach Anspruch 10 oder 11 für die Erfassung von Sprengstoffen in Gepäckstücken.

**Claims**

1. Device for conversion of current pulses into voltage pulses comprising:

- an integrator circuit comprising a first capacitor (Cint) and a first resistor (Rp) placed in parallel between the output and the inverting input of an operational amplifier (A1), said inverting input to said operational amplifier (A1) receiving said current pulses;
- a delay line (DL) receiving said output (vout) from said integrator circuit and generating a delay (Δ);

**characterised in that** said delay line (DL) comprises at least one memory cell, said memory cell comprising:

- a second capacitor (Ce) and a second resistor (Re) mounted in parallel, the product of said first resistor (Rp) and said first capacitor (Cint) being equal to the product of said second resistor (Re) and said second capacitor (Ce);
- a write switch connected to a first common node to the second capacitor and the second resistor, capable of charging the second capacitor from the output from the integrator circuit when it is conducting and memorising the voltage at the terminals of the capacitor when it is in high impedance;
- a read switch connected to the first common node and capable of reading the voltage of this node when the read switch is conducting;

the conversion device also comprising subtraction means to subtract the voltage memorised at the terminals of the capacitor at the output from the integrator circuit and provide the voltage difference thus obtained.

2. Device for conversion of current pulses into voltage pulses according to claim 1, **characterised in that** the second capacitor and the second resistor are connected to a second common node connected at the output from the integrator circuit, and **in that** the read switch connects the first common node to the ground when it is conducting.

3. Device for conversion of current pulses into voltage pulses according to claim 1, **characterised in that** the write switch connects the first common node to the output from the integrator circuit when it is conducting, and the read switch connects the first common node to a first negative input to the subtraction means when it is conducting, the output from the integrator circuit being connected to a second negative input to the subtraction means.

4. Device for conversion of current pulses into voltage pulses according to claim 3, **characterised in that** the second capacitor is placed between the first common node and a first reference potential (Vref1) and **in that** the second resistor is placed between the first common node and a second reference potential (Vref2).

5. Device for conversion of current pulses into voltage pulses according to claim 1, **characterised in that** it also comprises logical means capable of sending to each of said memory cells in sequence, a first signal to said write switch and a second signal to said read switch, said signal being offset in time from said first signal, and said time offset (x) being defined as a function of the chosen delay (Δ).

6. Device for conversion of current pulses into voltage pulses according to claim 4, **characterised in that** said second reference potential (Vref2) is equal to the continuous potential of said inverting input to said operational amplifier (A1).

7. Device for conversion of current pulses into voltage pulses according to any one of the previous claims, **characterised in that** the delay (Δ) is chosen to be longer than the rise time of the signal at the output from the integrator circuit (vout).

8. Device for conversion of current pulses into voltage pulses according to any one of the previous claims, **characterised in that** it can be integrated into an application specific integrated circuit (ASIC).

9. Device for conversion of current pulses into voltage pulses according to any one of the previous claims, **characterised in that** it can be made using a CMOS technology.

10. System for detection of ionising electromagnetic radiation, **characterised in that** it comprises an ionising electromagnetic radiation detector (910) capable of receiving incident photons (ph) and emitting current pulses at its output, a device for conversion of current pulses into voltage pulses (900) according to any one of the previous claims, connected to the output from said detector (1), and a digital-analogue converter (940) at the output from said device for conversion of current pulses into voltage pulses.

11. System for detection of ionising electromagnetic radiation according to claim 10, **characterised in that** said ionising electromagnetic radiation detector (910) is a semiconductor detector.

12. Use of a system for detection of ionising electromagnetic radiation according to claim 10 or 11 for detection of explosives in luggage.

FIG.1

FIG.2

FIG.3

FIG.4

■ V (out1theo)

♦ V (delayout1theo)

▼ V (energietheo)

FIG.5A

FIG.6A

## FIG.5B

## FIG.6B

FIG.7

FIG.8

FIG.9

**EP 2 766 990 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2951037